Europäisches Patentamt

European Patent Office

Office européen des brevets

(19)

(11) Publication number: **0 127 815 B1**

## EUROPEAN PATENT SPECIFICATION

(12)

(45) Date of publication of patent specification: **22.07.92**  (51) Int. Cl.[5]: **G06F 5/00**

(21) Application number: **84105546.0**

(22) Date of filing: **16.05.84**

(54) Data compression method.

(30) Priority: **01.06.83 US 499943**

(43) Date of publication of application:
**12.12.84 Bulletin 84/50**

(45) Publication of the grant of the patent:
**22.07.92 Bulletin 92/30**

(84) Designated Contracting States:
**DE FR GB**

(56) References cited:
**EP-A- 0 129 439**
**US-A- 4 386 416**

**IEEE TRANSACTIONS ON INFORMATION THEORY, vol. IT-24, no. 5, septembre 1978, pages 530-536, IEEE, New York, US; J. ZIV et al.: "Compression of individual sequences via variable-rate coding"**

**IEEE TRANSACTIONS ON INFORMATION THEORY, vol. IT-29, no. 2, mars 1983, pages 284-287, IEEE, New York, US; G.G. LANGDON, Jr.: "A note on the Ziv-Lempel model for compressing individual sequences"**

(73) Proprietor: **International Business Machines Corporation**
**Old Orchard Road**
**Armonk, N.Y. 10504(US)**

(72) Inventor: **Miller, Victor Saul**
**626 Cardinal Road**
**Peekskill New York 10566(US)**
Inventor: **Wegman, Mark N.**
**127 West 70th Street, Apt. 4B**
**New York New York 10023(US)**

(74) Representative: **Schuffenecker, Thierry**
**Compagnie IBM France, Département de Propriété Intellectuelle**
**F-06610 La Gaude(FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

## BACKGROUND OF THE INVENTION

### 1. Field of the Invention

The present invention relates to data processing methods and more particularly to methods for compression of data for transmission or storage.

### 2. Description of the Prior Art

In the prior art there are many data compressing methods. The following are methods representative of the prior art.

An article entitled "Compression of Individual Sequences via Variable Rate Coding" by Ziv and Lempel published in the IEEE Transactions on Information Theory IT-24 pp 530-536, discloses a basic algorithm on which the present invention is an improvement, The structure, operation, advantages and disadvantages of the Lempel-Ziv method are discussed in greater detail in the Description of a Preferred Embodiment of the Present Invention. The prior art discussed above does not teach nor suggest the present invention as disclosed and claimed herein.

## SUMMARY OF THE INVENTION

Therefore, it is an object of the present invention to compress data for storage or transmission by a method including a character extension improvement, a string extension improvement, and a LRU algorithm improvement to enhance storage efficiency or to enhance transmission efficiency and to reduce line costs in remote terminal data communications systems.

It is another object of the present invention to compress data for storage or transmission by a method including the steps of: initializing a set of strings to consist of n sequences; determining a longest string S of the set which matches a current string; generating an identifier I for S; transmitting I to a utilization device; testing dictionary for an empty slot; deleting a least recently used string from dictionary if no empty slot is found to create an empty slot; assigning a slot identifier j to said empty slot found or created from the above steps of testing and deleting; adding a new string S' to said set where S' comprises a concatenation of a previous string match and said current string match; assigning an identifier k to string S'; advancing the input position to a next character in said stream; outputting an identifier m to indicate a match; and repeating the above steps for a next string.

It is yet another object of the present invention to control data transmission between a host computing system and one or more remote terminals by the method set forth above.

Accordingly, a data compression and terminal communications control method according to the present invention includes the steps of : initializing a set of strings to consist of n sequences; determining a longest string S of the set which matches a current string; generating an identifier I for S; transmitting I to a utilization device; testing dictionary for an empty slot; deleting a least recently used string from dictionary if no empty slot is found to create an empty slot; assigning a slot identifier j to said empty slot found or created from the above steps of testing and deleting; adding a new string S' to said set where S' comprises a concatenation of a previous string match and said current string match; assigning an identifier k to string S'; advancing the input position to a next character in said stream; outputting an identifier m to indicate a match; and repeating the above steps for a next string.

The foregoing and other objects, features and advantages of the invention will be apparent from the more particular description of the preferred embodiments of the invention, as illustrated in the accompanying drawing.

## BRIEF DESCRIPTION OF THE DRAWING

FIG. 1 is a flow chart of a Prior Art method for data compression.

FIG. 2 is a flow chart of a data compression method according to the present invention including each component thereof.

FIG. 3 is a flow chart of a first component of a data compression method according to the present invention.

FIG. 4 is a flow chart of a second component of a data compression method according to the present invention.

FIG. 5 is a flow chart of a third component of a data compression method according to the present invention.

In the drawing, like elements are designated with similar reference numbers, and identical elements in different specific embodiments are designated by identical reference numbers.

## DESCRIPTION OF PREFERRED EMBODIMENT OF THE INVENTION

## THE PRIOR ART COMPRESSION METHODS OF LEMPEL AND ZIV

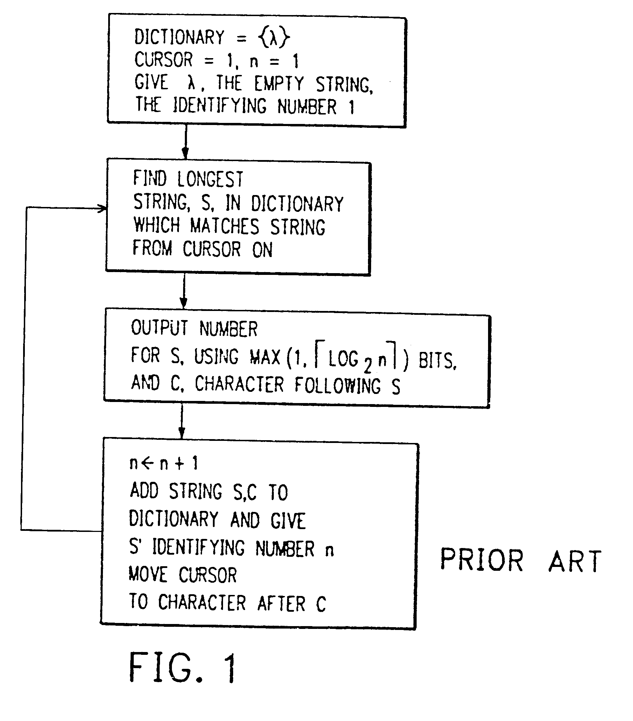

Lempel and Ziv (LZ) propose two related methods for data compression which are based on the theory of algorithmic complexity, rather than more traditional probability based approaches. The second, simpler, method can be implemented straightforwardly and efficiently, and produces satisfactory compression on most data. However, the method has some shortcomings, which are remedied by the present invention. In the following discussion, the term encoder is used for the compression program, and decoder for the inverse operation. The LZ algorithm is shown in fig 1.

It is adaptive. Thus, it can work on a wide variety of different file types and still get acceptable performance.

It can be thought of as a general model for compression. Both the encoder and the decoder maintain a dictionary of strings, and at every point those dictionaries change in lock-step, so that bits need not be used to transmit the dictionary. This is possible because strings are only added to the dictionary after the decoder would have seen them, and it uses the exact same strategy for adding them to the dictionary as the encoder.

LZ records probable events and does not waste space with information about improbable events. If one wanted to have a Huffman code compressing all pairs of characters. One would need 64k pieces of information. And one would only have information about diagram frequency. (An n-gram is a string of n characters). With the above method if there is a 100-gram which is more common than a single letter, the system will "learn" that 100-gram first.

It may well be more important to store information that strings of 80 blanks long (lines) occur often than that the letter "z" appears with some given frequency. Lines of blanks will be more important than the letter 'z' if they occur more often, and this is precisely the case when LZ stores information on them.

Another feature is that there is a good representation for the dictionary. It is possible to keep a fixed number of bits for each dictionary entry, no matter how long the string of characters represented by that dictionary entry is.

The first problem with the above method is that part of the output consists of uncompressed symbols from the input. While this is of little consequence asymptotically, it is of significant consequence for practical data. For example, if a file is partitioned into 20,000 sequences by the above algorithm, over one-third of the output will consist of uncompressed characters.

THE PRESENT INVENTION

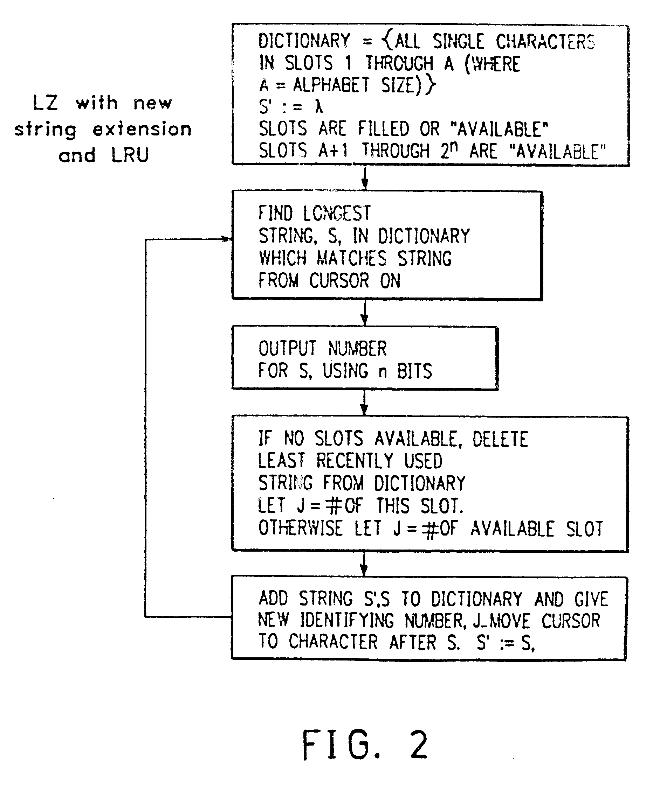

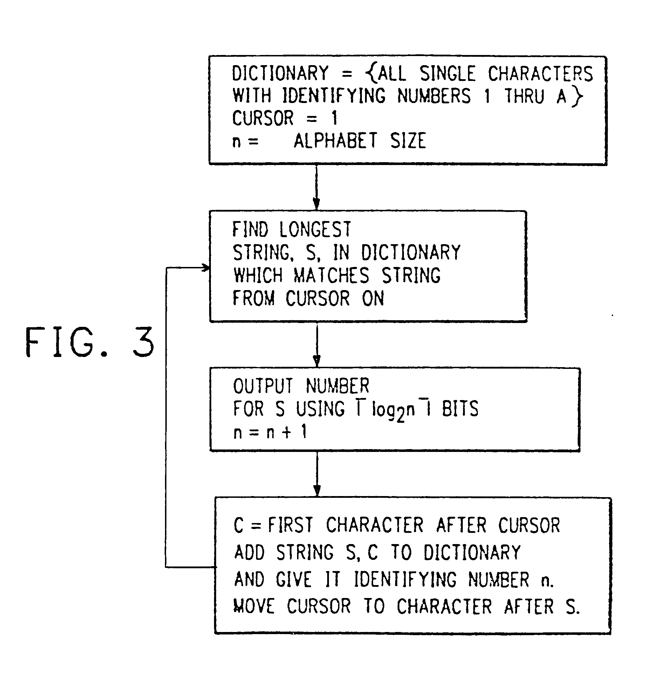

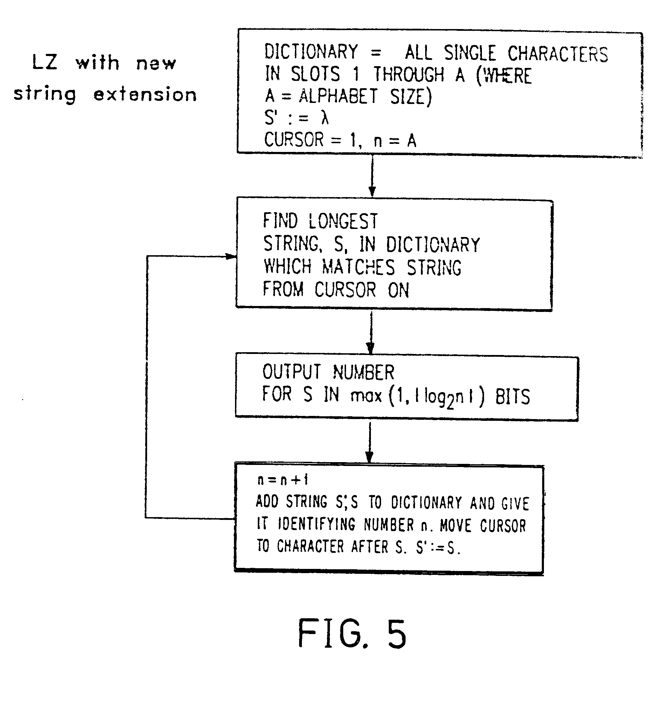

The solution proposed here avoids transmitting any uncompressed data. The entire output consists of a sequence of identifying numbers. The present invention will be described with reference to figures 2, 3, 4, and 5.

Referring now to fig. 2, the method according to the present invention will be described.

The first step of the present invention initializes the dictionary to contain all strings of length 1, instead of initializing the dictionary to contain the empty string. Thus, a match is always found. The dictionary must be augmented by adding the string S concatenated with the first character of the next string which is matched. This new string is added after the next match has been found.

Next, in step 2, since the first character of a string is always known, the longest string, S, is found in the dictionary which matches the current string in the data stream from the cursor forward.

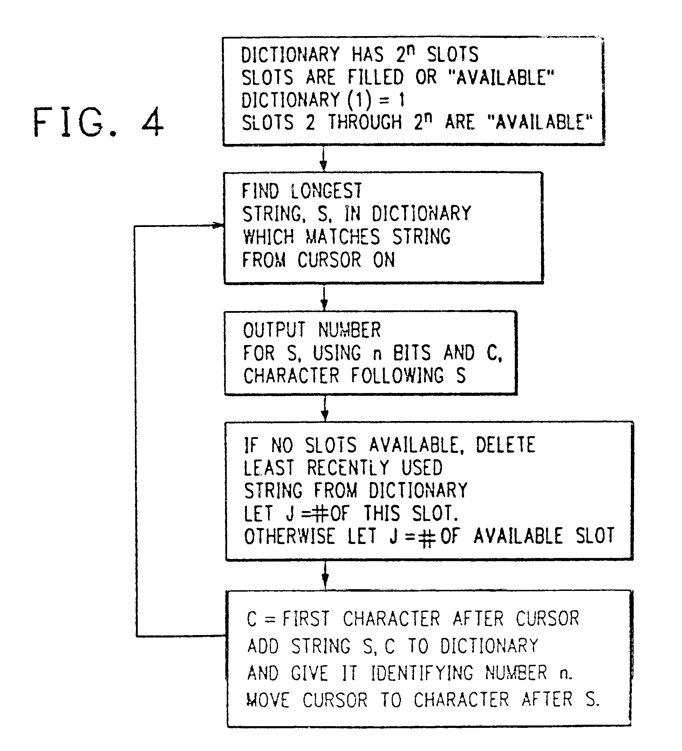

Another assumption made by Lempel and Ziv is that the dictionary can grow to an infinite size. This is clearly not practical. The method recommended by Lempel and Ziv is to block the input, into those segments whose dictionaries just fill up available space, compressing each block independently. However it is more advantageous to replace individual strings in the dictionary. Step 3 of the present method discards strings which have been in some sense least recently used. (See fig. 4) A string is defined as "used" if it is matched, or is a prefix of a match. The other definition associates a reference count with each string in the dictionary. The reference count of a string S, is the number of strings in the dictionary which are of the form S∥T, or T∥S, for some T (S∥S is counted twice). Among those strings with reference count 0, the one whose reference count has been 0 the longest is the "least recently used."

In some sense the dictionary should be filled with the natural units of the file being compressed. In English this would mean that most entries in the dictionary would be words, or even phrases. However, the method used to build up larger units must go through transitions which are not units. So, one might have a unit composed of one word, plus the first half of another word. It is less likely to have the last part of that word in the dictionary, than the whole word. Moreover, if pieces of words are stored in the dictionary, they may make the dictionary bigger than it should be. For example if three fourths of the dictionary has strings which are never, or rarely used then two extra bits will be used in the transmission of each bit so that these useless entries can be referred to. Furthermore, it takes a long time to adapt to long strings. All these problems can be eliminated or ameliorated by adding into the dictionary entries which are the concatenation of two matches rather than the concatenation of the first match and the first character of the second match.

Combining the three concepts, a powerful encoder is achieved whose embodiment is discussed next.

The major difficulties in obtaining a practical implementation are in finding a good data structure for the dictionary of strings. This structure should be small, yet allow rapid searches.

First will be described a data structure sufficient for all the encodings save the last presented. The size of all these structures is proportional to the number of strings in the dictionary, and does not depend on the size of the strings.

In the first encodings all strings, S, in the dictionary are either one character longer than a prefix, P, of S, with P being in the dictionary, or S is one character long. Thus the dictionary resembles a tree. The root of the tree is the empty string. Each node (except for the root) is the child of the node representing the string labeling the node with the last symbol omitted. In the encoding algorithm the recognition is accomplished by first recognizing a prefix and then seeing if it has a child which matches the next character. Let n be a node with parent, P, C being the last character of the string corresponding to n (the character which is not in the string corresponding to P). A hash table, which may be implemented by one of a number of hash functions, such as is shown in "Universal Classes of Hash Functions" J. Lawrence Carter and Mark N. Wegman, Journal of Computer and System Sciences Vol 18 No 2 Apr 79, pp 143 - 154, indexed by the pair (P,C) returns n if there is such a child. Hashing techniques are well known to those skilled in the art and need not be set forth in detail herein. Thus, given a node, one can quickly tell if there is a longer match. The decoding algorithm works similarly, but instead of a hash table a simple pointer from n to P suffices.

The least recently used encoding presents little problem. The only thing worth noting is that holes cannot be left in the dictionary. Thus the string 'abc' cannot stay in the dictionary when the string 'ab' is thrown out. The simplest strategy is to only place strings on the LRU list when they are leaves of the tree. Thus, a new string or one whose children have been deleted become candidates for deletion.

The string concatenation method is more difficult. Two data structures must be maintained. One structure is called the discriminator tree, and is used to rapidly find candidates for matches. This structure resembles the above dictionary and is similar to a prefix tree. The other data structure is called the pair forest and it allows one to choose between the candidates. The pair forest succinctly represents all strings. Each string is represented by a node. A node is either a character, or two pointers to other nodes. Thus the concatenation of two strings in the dictionary can be represented by a node which points to both. All nodes in the forest are placed in an array, the ith element of which points to the ith string in the dictionary.

The discriminator tree maintains the property that the parent, P, of a node, n, corresponds to a prefix of the string represented by n. However the prefix may be more than one character shorter. Moreover, not all nodes in the tree necessarily correspond to strings in the dictionary; they may be prefixes of strings in the dictionary.

All strings in the dictionary which are not prefixes of other strings in the dictionary correspond to leaves in the discriminator tree. All other strings in the dictionary are also placed in the tree as internal nodes. If S is the prefix of two or more strings, $S:sub./1/$ and $S:sub./2/$ , which are in the dictionary and S is the longest such string, then a node, N, corresponding to S is in the tree, even if S is not in the dictionary. Since we cannot store S efficiently, we store in n a pointer to either $S:sub./1/$ or $S:sub./2/$ in the pair forest. From this information it is possible to re-create S.

With each node is stored the length of the string that it matches. A hash table, as above, allows us to find the appropriate child from a parent. So, if we are trying to match a string which is a leaf in the tree, start at the root, and hash the first character to find the next node. From this node find the length of the string it matches, and hence the character beyond it. Hash the node and that character to obtain the next node. This process is repeated to find a candidate match. A problem arises if the candidate match does not match the text on a character which was not used in the bashing process.

At this point the real match in the dictionary must either be the string found by the discriminator tree or a prefix of it. The pair forest is used to find the longest prefix of the candidate match that matches the text being compressed. As this process goes on, the discriminator tree is scanned to find the longest string in the dictionary which corresponds to this prefix. That string is the correct match.

It should be pointed out, that in the string extension algorithm the possibility arises that when adding a string to the discriminator tree, that it is already there. In that case no changes should be made to the discriminator tree.

The method proposed herein can also be used to produce a probability distribution for the next character in a string of characters (or bit in a string of bits). This may be useful in applications involving recognizing data. For example, optical scanners can often tell that a particular character is either an "n" or an "h". However, they may have difficulty distinguishing between them. In such a case, if the probability is very low of an "h" following the current string of characters, the scanner might decide that the next character is an "n". Another example is recognizing Phonemes or words in speech recognition.

A number of authors have shown that any compression method can be used to make a prediction. For example, see Thomas M. Cover "Universal Gambling Schemes and the Complexity Measures of Kolmogorov and Chaitin" in technical report no. 12, Oct 14 1974, Dept. of Statistics, Stanford University.

## Claims

1. A method for data compression of individual sequences in a data stream, comprising the steps of:

   initializing a dictionary consisting of a set of strings with an index for each of said strings and including all possible strings of length 1;

   setting a current input position at the beginning of said data stream and repeating the following steps until the data stream to be compressed is exhausted;

   determining a longest string S in said dictionary which matches a current string in the data stream starting from the current input position;

   generating an identifier I for S consisting of an encoding of the index associated with said longest matched string S;

   advancing the current input position to immediately after said current string in the data stream;

   modifying said dictionary based on the preceding longest matched string S, the immediately succeeding symbols in the next string in the data stream, and the sequence of previously matched strings;

   transmitting I to a utilization device; and

   decoding I at said utilization device to recover said string S.

2. A method according to claim 1, wherein said modifying step comprises the steps of:

   adding a new string S' to said set, where S' comprises a concatenation of said current string match and an immediately succeeding symbol in said data stream; and

assigning an identifier I' to said string S'.

3. A method according to claim 2, further comprising the step of:

   testing a dictionary of fixed size in storage containing said set of strings for an empty slot to store said new string S', and if an empty slot is not found, deleting a string from the dictionary in order to create an empty slot.

4. A method according to claim 3, wherein the step of deleting comprises deleting a least recently used string from said dictionary to create an empty slot, if no empty slot is found.

5. Apparatus for data compression of individual sequences arranged in a data stream, comprising:

   means for initializing a dictionary consisting of a set of strings with a index for each of said strings and including all possible strings of length 1;

   means for setting a current input position at the beginning of said data stream;

   means for determining a longest string S in said dictionary which matches a current string in the data stream starting from the current input position;

   means for generating an identifier I for S consisting of an encoding of the index associated with said longest matched string S;

   means for advancing the current input position to immediately after said current string in the data stream;

   means for modifying said dictionary based on the preceding longest matched string S, the immediately succeeding symbols in the next string in the data stream, and the sequence of previously matched strings;

   means for transmitting I to a utilization device; and

   means for decoding I at said utilization device to recover said string S, and,

   means for repeating the steps of initializing, setting a current input position, determining, generating, advancing, modifying, transmitting and decoding until the data stream to be compressed is exhausted;

6. Apparatus according to claim 5, wherein said modifying means comprises:

means for adding a new string S' to said set, where S' comprises a concatenation of said current string match and an immediately succeeding symbol in said data stream; and

means for assigning an identifier I' to said string S'.

7. Apparatus according to claim 6, further comprising:

storing a dictionary of fixed size containing said set of strings,

means for testing said dictionary for an empty slot to store said new string S', and

means for deleting a string from the dictionary in order to create one, if an empty slot is not found.

8. Apparatus according to claim 7, wherein the means for deleting a string comprises means for deleting a least recently used string from said dictionary to create an empty slot, if no empty slot is found.

**Revendications**

1. Procédé pour la compression des données des séquences individuelles dans un train de données, comprenant les étapes consistant à :

initialiser un dictionnaire constitué d'un ensemble de chaînes avec un index pour chacune desdites chaînes et comportant toutes les chaînes possibles de longueur 1 ;

établir une position d'entrée courante au commencement dudit train de données et répéter les étapes suivantes jusqu'à ce que le train de données qui doit être comprimé soit sorti ;

déterminer une chaîne S la plus longue dans ledit dictionnaire qui s'apparie avec une chaîne courante dans le train de données commençant à partir de la position d'entrée courante ;

produire un identificateur I pour S qui est constitué du codage de l'index associé à ladite chaîne la plus longue appariée S ;

avancer la position d'entrée courante à ladite chaîne courante immédiatement suivante dans le train de données ;

modifier ledit dictionnaire basé sur la chaîne précédente la plus longue appariée S, les symboles successifs immédiatement suivants dans la prochaine chaîne dans le train de données et la séquence des chaînes précédentes appariées ;

transmettre I vers un dispositif utilisateur, et

décoder I audit dispositif utilisateur pour récupérer ladite chaîne S.

2. Procédé selon la revendication 1, dans lequel ladite étape de modification comprend les étapes consistant à :

ajouter une nouvelle chaîne S' audit ensemble, où S' constitue une concaténation dudit appariement de chaîne courante et d'un symbole immédiatement suivant dans ledit train de données, et

affecter un identificateur I' à ladite chaîne S'.

3. Procédé selon la revendication 2, comprenant de plus l'étape consistant à :

tester un dictionnaire de volume fixe dans la mémoire contenant ledit ensemble de chaînes pour un emplacement vide afin de mémoriser ladite nouvelle chaîne S' et si la place vide n'est pas trouvée, supprimer une chaîne du dictionnaire afin de créer un emplacement vide.

4. Procédé selon la revendication 3, dans lequel l'étape consistant à supprimer une chaîne comprend la suppression de la chaîne la moins récemment utilisée à partir du dictionnaire pour créer un emplacement vide, si aucun emplacement vide n'est trouvé.

5. Dispositif pour la compression des données des séquences individuelles disposées en un train de données, comprenant :

un moyen pour initialiser un dictionnaire constitué d'un ensemble de chaînes avec un index pour chacune desdites chaînes et comportant toutes les chaînes possibles de longueur 1 ;

un moyen pour établir une position d'entrée courante au début dudit train de données ;

un moyen pour déterminer une chaîne la plus longue S dans ledit dictionnaire qui s'apparie à une chaîne courante dans ledit train de données commençant à partir de la position d'entrée courante ;

un moyen pour produire un identificateur I pour S constitué de l'encodage de l'index associé à ladite chaîne la plus longue appariée S ;

un moyen pour avancer la position d'entrée courante à ladite chaîne courante immédiatement suivante dans ledit train de données

;

un moyen pour modifier ledit dictionnaire basé sur la chaîne précédente appariée la plus longue S, les symboles immédiatement suivants dans la prochaine chaîne dans le train de données et la séquence des chaînes précédemment appariées ;

un moyen pour transmettre I à un dispositif utilisateur, et

un moyen pour décoder I audit dispositif utilisateur pour récupérer ladite chaîne S, et

un moyen pour répéter les étapes consistant à initialiser, établir une position d'entrée courante, produire, déterminer, avancer, modifier, transmettre et décoder jusqu'à ce que le train de données qui doit être comprimé soit sorti.

6. Dispositif selon la revendication 5, dans lequel ledit moyen de modification comprend :

un moyen pour ajouter une nouvelle chaîne S' audit ensemble, où S' comprend une concaténation dudit appariement de chaînes courantes et d'un symbole immédiatement suivant dans ledit train de données, et

un moyen pour affecter un identificateur I' à ladite chaîne S'.

7. Dispositif selon la revendication 6, comprenant de plus :

la mémorisation d'un dictionnaire de volume fixe contenant ledit ensemble des chaînes,

un moyen pour tester ledit dictionnaire pour un emplacement libre afin de mémoriser ladite nouvelle chaîne S', et

un moyen pour supprimer une chaîne du dictionnaire afin d'en créer une, si un emplacement vide n'est pas trouvé.

8. Dispositif selon la revendication 7, dans lequel le moyen pour supprimer une chaîne comprend un moyen pour supprimer une chaîne la moins récemment utilisée à partir du dictionnaire pour créer un emplacement vide, si aucun emplacement vide n'est trouvé.

## Patentansprüche

1. Verfahren zum Komprimieren von Daten in einzelnen Folgen in einem Datenstrom, welches die folgenden Schritte umfaßt:

Initialisieren eines Wörterbuchs, das aus einem Satz von Ketten mit einem Index für jede der Ketten besteht und alle möglichen Ketten mit einer Länge 1 enthält,

Setzen einer aktuellen Eingabeposition an dem Anfang des Datenstroms und Wiederholen der folgenden Schritte solange, bis der Datenstrom ausgeschöpft ist, der komprimiert werden soll,

Bestimmen einer längsten Kette S in dem Wörterbuch, die zu einer aktuellen Kette in dem Datenstrom beginnend von der aktuellen Eingabeposition paßt,

Erzeugen einer Identifizierung I für S, die aus einer Codierung des Index besteht, welcher der längsten angepaßten Kette S zugeordnet ist,

Voranschieben der aktuellen Eingabeposition unmittelbar nach der aktuellen Kette in dem Datenstrom,

Ändern des Wörterbuchs auf der Grundlage der vorangehenden längsten angepaßten Kette S, der unmittelbar nachfolgenden Symbole in der nächsten Kette in dem Datenstrom und der Folge vorangehend angepaßter Ketten,

Übertragen von I zu einer Benutzungseinrichtung und

Decodieren von I bei der Benutzungseinrichtung, um die Kette S wiederherzustellen.

2. Verfahren nach Anspruch 1, bei welchem der Schritt des Änderns die folgenden Schritte umfaßt:

Hinzufügen einer neuen Kette S' zu dem Satz, wo S' eine Verkettung der aktuellen Kettenanpassung und eines unmittelbar nachfolgenden Symbols in dem Datenstrom enthält und

eine Identifizierung I' wird der Kette S' zugewiesen.

3. Verfahren nach Anspruch 2, das ferner den folgenden Schritt umfaßt:

Prüfen eines Wörterbuchs mit fester Speichergröße, welches den Satz von Ketten für einen leeren Schlitz zum Speichern der neuen Kette S' enthält und, falls ein leerer Schlitz nicht gefunden wird, Löschen einer Kette in dem Wörterbuch, um einen leeren Schlitz zu erzeugen.

4. Verfahren nach Anspruch 3, bei welchem der Schritt des Löschens das Löschen einer LRU-Kette in dem Wörterbuch umfaßt, um einen leeren Schlitz zu erzeugen, falls kein leerer Schlitz gefunden wird.

**5.** Einrichtung zum Komprimieren von Daten in einzelnen in einem Datenstrom gruppierten Folgen, die folgendes aufweist:

Mittel zum Initialisieren eines Wörterbuchs, das aus einem Satz von Ketten mit einem Index für jede der Ketten besteht und alle möglichen Ketten mit einer Länge 1 enthält,

Mittel zum Setzen einer aktuellen Eingabeposition an den Anfang des Datenstroms,

Mittel zum Bestimmen einer längsten Kette S in dem Wörterbuch, die zu einer aktuellen Kette in dem Datenstrom beginnend von der aktuellen Eingabeposition paßt,

Mittel zum Erzeugen einer Identifizierung I für S, die aus einer Codierung des Index besteht, welcher der längsten angepaßten Kette S zugeordnet ist,

Mittel zum Voranschieben der aktuellen Eingabeposition unmittelbar nach der aktuellen Kette in dem Datenstrom,

ein Mittel zum Ändern des Wörterbuchs auf der Grundlage der vorangehenden längsten angepaßten Kette S, der unmittelbar nachfolgenden Symbole in der nächsten Kette in dem Datenstrom und der Folge vorangehend angepaßter Ketten,

Mittel zum Übertragen von I zu einer Benutzungseinrichtung und

Mittel zum Decodieren von I bei der Benutzungsreinrichtung, um die Kette S wiederherzustellen und

Mittel zum Wiederholen der Schritte des Initialisierens, des Setzens einer aktuellen Eingabeposition, des Bestimmens, Erzeugens, Voranschiebens, Änderns, Übertragens und Decodierens solange, bis der Datenstrom ausgeschöpft ist, der komprimiert werden soll.

**6.** Einrichtung nach Anspruch 5, bei welcher das Mittel zum Ändern folgendes aufweist:

Mittel zum Hinzufügen einer neuen Kette S' zu dem Satz, wo S' eine Verkettung der aktuellen Kettenanpassung und eines unmittelbar nachfolgenden Symbols in dem Datenstrom enthält und

Mittel, um der Kette S' eine Identifizierung I' zuzuweisen.

**7.** Einrichtung nach Anspruch 6, die ferner folgendes aufweist:

Speicherung eines Wörterbuchs fester Größe, welches den Satz von Ketten enthält,

Mittel zum Prüfen des Wörterbuchs auf einen leeren Schlitz hin, um die neue Kette S' zu speichern und

ein Mittel zum Löschen einer Kette in dem Wörterbuch, um eine solche zu erzeugen, falls ein leerer Schlitz nicht gefunden wird.

**8.** Einrichtung nach Anspruch 7, bei welcher das Mittel zum Löschen einer Kette Mittel zum Löschen einer LRU-Kette in dem Wörterbuch zum Erzeugen eines leeren Schlitzes aufweist, falls kein leerer Schlitz gefunden wird.

FIG. 1

PRIOR ART

LZ with new
string extension
and LRU

DICTIONARY = {ALL SINGLE CHARACTERS
IN SLOTS 1 THROUGH A (WHERE
A = ALPHABET SIZE)}
$S' := \lambda$
SLOTS ARE FILLED OR "AVAILABLE"
SLOTS A+1 THROUGH $2^n$ ARE "AVAILABLE"

FIND LONGEST
STRING, S, IN DICTIONARY
WHICH MATCHES STRING
FROM CURSOR ON

OUTPUT NUMBER
FOR S, USING n BITS

IF NO SLOTS AVAILABLE, DELETE
LEAST RECENTLY USED
STRING FROM DICTIONARY
LET J = # OF THIS SLOT.
OTHERWISE LET J = # OF AVAILABLE SLOT

ADD STRING S',S TO DICTIONARY AND GIVE
NEW IDENTIFYING NUMBER, J. MOVE CURSOR
TO CHARACTER AFTER S. $S' := S$,

# FIG. 2

DICTIONARY = {ALL SINGLE CHARACTERS
WITH IDENTIFYING NUMBERS 1 THRU A}
CURSOR = 1
n =   ALPHABET SIZE

FIND LONGEST
STRING, S, IN DICTIONARY
WHICH MATCHES STRING
FROM CURSOR ON

**FIG. 3**

OUTPUT NUMBER
FOR S USING $\lceil \log_2 n \rceil$ BITS
n = n + 1

C = FIRST CHARACTER AFTER CURSOR
ADD STRING S, C TO DICTIONARY
AND GIVE IT IDENTIFYING NUMBER n.
MOVE CURSOR TO CHARACTER AFTER S.

FIG. 4

DICTIONARY HAS $2^n$ SLOTS
SLOTS ARE FILLED OR "AVAILABLE"
DICTIONARY (1) = 1
SLOTS 2 THROUGH $2^n$ ARE "AVAILABLE"

FIND LONGEST
STRING, S, IN DICTIONARY
WHICH MATCHES STRING
FROM CURSOR ON

OUTPUT NUMBER
FOR S, USING n BITS AND C,
CHARACTER FOLLOWING S

IF NO SLOTS AVAILABLE, DELETE
LEAST RECENTLY USED
STRING FROM DICTIONARY
LET J = # OF THIS SLOT.
OTHERWISE LET J = # OF AVAILABLE SLOT

C = FIRST CHARACTER AFTER CURSOR
ADD STRING S, C TO DICTIONARY
AND GIVE IT IDENTIFYING NUMBER n.
MOVE CURSOR TO CHARACTER AFTER S.

LZ with new
string extension

DICTIONARY = ALL SINGLE CHARACTERS
IN SLOTS 1 THROUGH A (WHERE
A = ALPHABET SIZE)
S' : = λ
CURSOR = 1, n = A

FIND LONGEST
STRING, S, IN DICTIONARY
WHICH MATCHES STRING
FROM CURSOR ON

OUTPUT NUMBER
FOR S IN $\max(1, \lceil \log_2 n \rceil)$ BITS

n = n + 1
ADD STRING S';S TO DICTIONARY AND GIVE
IT IDENTIFYING NUMBER n. MOVE CURSOR
TO CHARACTER AFTER S. S':=S.

# FIG. 5